# EUROPEAN PATENT APPLICATION

(11) **EP 2 420 597 A1**
(43) Date of publication of application: **22.02.2012**
(21) Application number: 10783140.6
(22) Date of filing: 01.06.2010
(51) Int. Cl.: C30B 15/10, B65D 43/02, B65D 77/20, C30B 29/06

(54) **LID FOR FUSED QUARTZ CRUCIBLE, FUSED QUARTZ CRUCIBLE AND METHOD FOR HANDLING SAME**

(30) Priority: 02.06.2009 JP 2009133253
(71) Applicant: Japan Super Quartz Corporation, Akita-shi Akita 010-0065 (JP); SUMCO Corporation, Minato-ku Tokyo 105-8634 (JP)
(72) Inventor: SATO, Masaru, Akita-shi Akita 010-0065 (JP); OHARA, Masami, Akita-shi Akita 010-0065 (JP); TAKASE, Nobumitsu, Tokyo 105-8634 (JP)
(74) Representative: Gulde Hengelhaupt Ziebig & Schneider
(86) International application number: PCT/JP2010/003668
(87) International publication number: WO 2010/140352

(57) **Abstract**

By providing a method capable of avoiding invasion of starting material powder for crucible into an inner face of the crucible, it is made possible to reliably avoid the invasion of foreign substances into a vitreous silica crucible until an actual use time of the crucible and to handle the crucible with no contamination. A cover 3 mounted onto an opening portion 2 of a vitreous silica crucible 1, comprising a flange portion 4 in close contact with an outer peripheral end 2a of the opening portion 2, is mounted onto the crucible 1.

## Description

### TECHNICAL FIELD

This invention relates to a vitreous silica crucible, and more particularly to a vitreous silica crucible used in a pulling step for the production of single crystal silicon. Particularly, it provides a structure of avoiding invasion of foreign substances into an inner face of a fabricated vitreous silica crucible during storage and transportation of the crucible.

### BACKGROUND ART

In the production of single crystal silicon, it is general that vitreous silica crucibles used in the melting of polycrystalline silicon as a raw material are washed and inspected after the fabrication, and thereafter acceptable products are shipped by bagging or the like.
With the increase of purity in semiconductor materials, it is important to suppress various contaminations during the production of single crystal silicon, and hence it is desired to control the contamination even in the vitreous silica crucibles at minimum. That is, when the vitreous silica crucible is used for pulling a single crystal, it is paid careful attention to the contamination by washing the inside of the crucible with ultra-pure water or the like prior to use. For this end, it is first important to prevent contamination by dust or the like even in a period of time from the shipping to the use of the fabricated crucible.
Recently, the size of the vitreous silica crucible particularly tends to be gradually increased for enhancing the production efficiency of single crystal silicon. However, such a large-diameter crucible is not easy in the handling, and is apt to be easily contaminated even in the operation such as inspection, bagging or the like after the fabrication of the crucible.

In order to solve such a problem, Patent Document 1 proposes a apparatus of automatically wrapping a washed vitreous silica crucible at a clean state for the purpose of mechanically packing the vitreous silica crucible at a clean state after the washing thereof.

### PRIOR ART REFERENCE

### PATENT DOCUMENT

Patent Document 1: JP-A-2000-219207

### SUMMARY OF THE INVENTION

### PROBLEMS TO BE SOLVED BY THE INVENTION

By wrapping with an apparatus described in Patent Document 1, it is made possible to store the washed vitreous silica crucible at a clean state and particularly avoid contamination in the shipping. However, such wrapping requires an expensive apparatus and cannot be reused, so that the cost for preventing contamination inside the crucible has been enormous. Therefore, it is desired to provide a method for avoiding contamination inside the vitreous silica crucible at low cost.

It is, therefore, an object of the invention to reliably avoid invasion of foreign substances into an inside of a vitreous silica crucible at low cost up to an actual use time of the crucible to thereby enable handling of the crucible with no contamination.

### MEANS FOR SOLVING THE PROBLEMS

The summary and construction of the invention are as follows:
(1) A cover for a vitreous silica crucible to be mounted onto an opening portion of a vitreous silica crucible, comprising a flange portion in close contact with an outer peripheral end of the opening portion.

(2) A cover for a vitreous silica crucible according to the item (1), wherein an adhesive member is disposed on an area of the cover contacting with a circumferential end face of the opening portion.

(3) A cover for a vitreous silica crucible according to the item (1), wherein an elastic member is disposed on an area of the cover contacting with a circumferential end face of the opening portion.

(4) A cover for a vitreous silica crucible according to the item (1), (2) or (3), wherein an amount of metal components attached to at least an inner surface of the cover is not more than 0.05 ng/cm².

(5) A cover for a vitreous silica crucible according to any one of the items (1) to (4), wherein the cover has a flexibility.

(6) A cover for a vitreous silica crucible according to any one of the items (1) to (5), wherein the cover has an identifier.

(7) A cover for a vitreous silica crucible according to any one of the items (1) to (6), wherein at least a part of the cover is transparent.

(8) A vitreous silica crucible having a disk-shaped cover at its opening portion, wherein a flange portion of the cover is fixed to an outer peripheral end of the opening portion into close contact therewith.

(9) A method of handling a vitreous silica crucible, wherein a cover as disclosed in any one of the items (1) to (7) is mounted onto an opening portion of the vitreous silica crucible during waiting time until polycrystalline silicon is charged into the vitreous silica crucible to conduct melting of the polycrystalline silicon in the production of single crystal silicon.

### EFFECT OF THE INVENTION

According to the invention is reliably avoided invasion of raw powder for a vitreous silica crucible into the inner face of the crucible and hence invasion of foreign substances into the inside of the vitreous silica crucible, so that the vitreous silica crucible can be handled without contaminating the inner face thereof over a period of time from the shipping of the crucible to the melting step of polycrystalline silicon.

### BRIEF DESCRIPTION OF THE DRAWINGS

FIG. 1 is a radial cross-sectional view of a crucible illustrating a cover for a crucible according to the invention.
FIG. 2 is a radial cross-sectional view of a crucible illustrating another cover for a crucible according to the invention.
FIG. 3 is a radial cross-sectional view of a crucible illustrating another cover for a crucible according to the invention.
FIG. 4 is a radial cross-sectional view of a crucible illustrating another cover for a crucible according to the invention.
FIG. 5 is a radial cross-sectional view of a crucible illustrating another cover for a crucible according to the invention.
FIG. 6 is a radial cross-sectional view of a crucible illustrating another cover for a crucible according to the invention.
FIG. 7 is a radial cross-sectional view of a crucible illustrating another cover for a crucible according to the invention.
FIG. 8 is a flow chart illustrating handling of a crucible.

### DESCRIPTION OF THE PREFERRED EMBODIMENTS

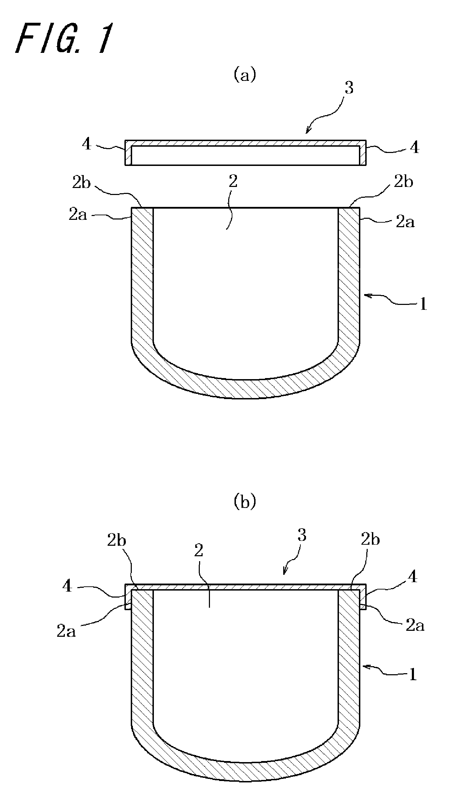

A vitreous silica crucible provided with a cover according to the invention will be described in detail with reference to the accompanying drawings. In FIG. 1(a) is shown a radial cross-section of a crucible before the mounting of a cover according to the invention, and FIG. 1(b) illustrates a radial cross-section of the crucible after the mounting of the cover.
In this figure, a reference symbol 1 is a vitreous silica crucible (hereinafter referred to as a crucible simply), and a cover 3 is mounted onto an opening portion 2 of the crucible 1. The cover 3 is a disk shape having a figure similar to the opening portion 2 and has a flange portion 4 closely contacting with an outer peripheral end 2a of the opening portion 2 of the crucible 1. That is, the cover 3 is attached to the opening portion 2 of the crucible 1 in a way that the flange portion 4 is brought into close contact with the outer peripheral end 2a. At this moment, it is preferable that a diameter of the flange portion 4 is equal to or slightly smaller than an outer diameter of the crucible 1 for covering the opening portion 2 without space.

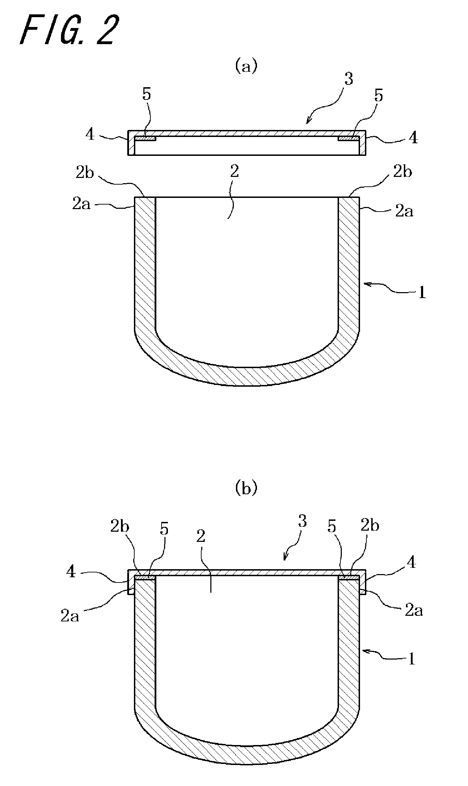

Furthermore, the cover 3 is made from a flexible material such as ABS resin, urethane resin, polyethylene, polypropylene, vinyl chloride, acrylic resin, polycarbonate or the like. In the mounting, the cover 3 as a whole or the flange portion 4 of the cover 3 is bent outward in a radial direction, which enables the flange portion 4 with the restoring force thereof to press against the outer peripheral end 2a as shown in FIG. 2(b). This is preferable in view of reliably conducting the detaching of the cover.

When the cover 3 having such a construction is mounted onto the opening portion 2 of the crucible 1, the cover 3 is brought into close contact with the outer peripheral end 2a and the circumferential end face 2b of the opening portion 2 to close the opening portion 2 reliably, whereby there is obviated such a scene that the starting material powder or the like attached onto the crucible 1 is guided into the inside, for example, through wrapping, so that invasion of foreign substances into the inside of the crucible can be avoided reliably.

As shown in FIG. 2, it is preferable that an adhesive member 5 is disposed at the inside of the cover 3 and on an area contacting with the circumferential end face 2b of the opening portion 2. Because, when the cover 3 provided with the adhesive member 5 is used and attached to the opening potion 2 of the crucible 1, the closely contacting between the crucible 1 and the cover 3 is more enhanced and the sealing performance of the crucible 1 as a container is further improved, which is effective for preventing invasion of foreign substance such as moisture or the like penetrating from a space between the cover 3 and the crucible 1. Moreover, since the moisture included in ambient air may be blended with metal elements deteriorating the performances of the crucible, it is preferable to reduce the penetration of the moisture for maintaining the performance of the crucible. The inventors have found that when the cover 3 is attached to the crucible 1 without interposing the adhesive member 5 as shown in FIG. 1, abrasion powder is generated by contacting the cover 3 with the circumferential end face 2b of the opening portion 2 of the crucible 1 and hence there is caused a possibility that the abrasion powder invades into the inside of the crucible 1 as foreign substances. However, when the adhesive member 5 is interposed between the cover 3 and the crucible 1 as shown in FIG. 2, abrasion powder is hardly generated, but also the generated abrasion powder is absorbed by the adhesive member 5, which makes it possible to suppress invasion of the abrasion powder into the crucible 1 more effectively. The term "adhesive member" used herein means an adhesive itself or an adhesive sheet formed by applying an adhesive onto any substrate, and it is desirable in terms of reliability of adhesion fixation, peeling simplicity and the like that the member is detachable to a target to be attached and a part of the member does not remain on the target even in the peeling after attachment. Moreover, the adhesive member 5 is preferable to have an elasticity from a viewpoint of improving the closely adhesion between the crucible 1 and the cover 3.

Alternatively, it is preferable to dispose an elastic member at the inside of the cover 3 and on an area contacting with the circumferential end face 2b of the opening portion 2 although not shown. Because, when the cover 3 provided with the adhesive member 5 is used and attached to the opening potion 2 of the crucible 1, the closely contacting between the crucible 1 and the cover 3 is more enhanced and the sealing performance of the crucible 1 as a container is further improved, which is effective for preventing invasion of foreign substance such as moisture or the like penetrating from a space between the cover 3 and the crucible 1. Moreover, since the moisture included in ambient air may be blended with metal elements deteriorating the performances of the crucible, it is preferable to reduce the penetration of the moisture for maintaining the performance of the crucible. Also, the generation of abrasion powder is suppressed likewise the adhesive member 5, and hence there is no possibility that abrasion powder invades into the inside of the crucible 1 as foreign substances. Furthermore, the elastic member is preferable to have an adhesion performance as mentioned above from a viewpoint of improving the closely adhesion between the crucible 1 and the cover 3.

The adhesive member and the elastic member used in the invention are not particularly limited as long as the above properties are fulfilled, but include, for example, acrylic ones and rubber-based ones. As the acrylic member is used an emulsion type member, and as the rubber-based member are used natural rubber, styrene-based synthetic block polymers (for example, SIS, SBS, SEBS (hydrogenated type of SBS), SIPS (hydrogenated type of SIS), and so on). Here, assuming that abrasion powder generated by contact between the cover 3 and the opening portion 2 of the crucible 1 invades into the inside of the crucible, it is preferable that the material of the adhesive member and the elastic member is silicon rubber being less in the influence of invasion.

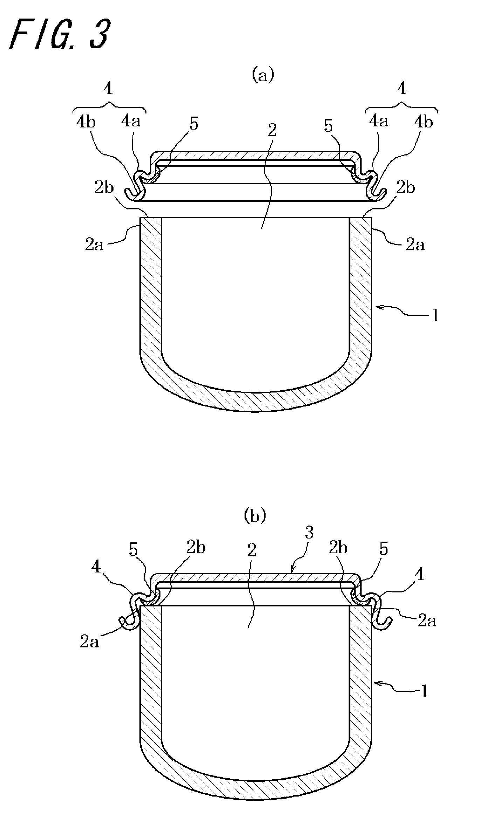

Furthermore, as shown in FIG. 3, it is possible that the flange portion 4 is bent toward the crucible at two stages so as to have a stepwise shape extending outward in a radial direction. Such a bent portion comprises a first bent section 4a located inward in the radial direction and a second bent section 4b located outward in the radial direction relative to the first bent section 4a. As shown in FIG. 3(b), when the cover 3 having such a construction is mounted onto the opening portion 2 of the crucible 1, the cover 3 is in close contact partially with the outer peripheral end 2a and the circumferential end face 2b of the opening portion 2, while the opening portion 2 is reliably closed and a contacting area of the cover 3 to the crucible 1 becomes small. Thus, even if the cover 3 is moved relative to the crucible 1 by vibration during transportation or the like and the crucible 1 and/or the cover 3 are worn by friction therebetween to generate abrasion powder, since the contacting area between the cover 3 and the crucible 1 is small, the amount of abrasion powder generated in proportion to the contacting area is decreased and hence it is made possible to avoid invasion of foreign substances into the crucible more effectively. Even in this case, when the cover 3 is mounted, the cover 3 as a whole or the flange portion 4 of the cover 3 is bent outward in a radial direction likewise the case shown in FIG. 1, which enables the flange portion 4 with the restoring force thereof to press against the outer peripheral end 2a as shown in FIG. 3(b), which is preferable in view of reliably conducting the detaching of the cover. Moreover, the cover 3 shown in FIG. 3 is provided with the adhesive member 5 likewise the cover shown in FIG. 2 from a viewpoint of suppressing invasion of foreign substances into the crucible.

According to the construction of the cover shown in FIG. 3, since the circumferential end face 2b of the opening portion 2 is covered with the flange portion 4, contamination to the circumferential end face 2b can be also avoided, which is particularly effective for avoiding incorporation of impurities in the pulling step for the production of single crystal silicon. In this case, it is preferable that a diameter of the flange portion 4 before attachment to the crucible 1 is equal to or smaller than an outer diameter of the crucible 1 for reliably covering the circumferential end face 2b to avoid contamination.

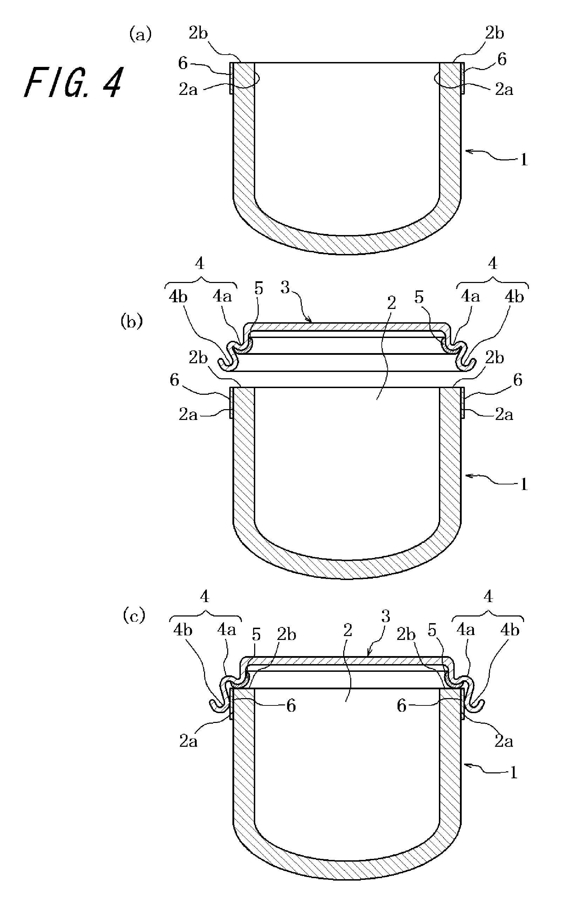

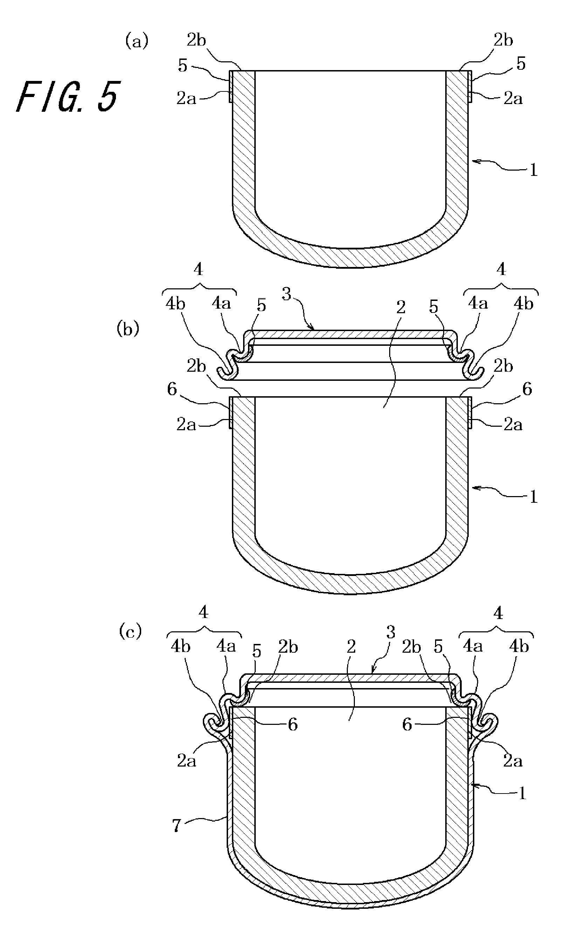

Furthermore, as shown in FIG. 4, it is preferable to interpose a band-shaped adhesive member 6 between the crucible 1 and the outer peripheral end 2a of the cover 3 when the cover 3 is attached to the crucible 1. First, as shown in FIG. 4(a), the band-shaped adhesive member 6 is attached onto the outer peripheral end 2a of the opening portion 2 of the crucible 1. Next, there is provided the cover 3 having the adhesive member 6 shown in FIG. 4(b), and then the cover 3 is attached to the crucible 1 so that the first bent section 4a is in contact with the circumferential end face 2b of the opening portion 2 and the second bent section 4b is in contact with the band-shaped adhesive member 6 as shown in FIG. 4(c). When the cover 3 having such a construction is mounted onto the opening portion 2 of the crucible 1, the opening portion 2 is reliably closed to obviate such a scene that the starting material powder or the like attached onto the crucible 1 is guided into the inside, for example, through wrapping, so that invasion of foreign substances into the inside of the crucible can be avoided reliably. Also, by the attachment of the cover 3 interposed with the band-shaped adhesive member 6 is further improved the sealing performance of the crucible 1 as a container, which is effective for preventing invasion of foreign substance such as moisture or the like penetrating from a space between the cover 3 and the crucible 1. Furthermore, since the cover 3 is attached via the adhesive member 6, frictional force between the cover 3 and the crucible 1 is improved to make the attachment of the cover 3 more stable. Therefore, contamination of the crucible 1 resulted from the cover coming off due to vibrations during transportation, and movement of the cover 3 relative to the crucible 1 are suppressed to prevent the generation of abrasion powder resulted therefrom, so that it is possible to avoid invasion of such abrasion powder into the crucible 1.
Moreover, as shown in FIGS. 5(a) to 5(c), it is possible to take such a construction that the cover 3 is attached to the crucible 1 with the band-shaped adhesive member 6 interposed between the crucible 1 and the cover 3 and thereafter a cup-shaped elastic member 7 is mounted onto the crucible 1 along the outer face of the crucible 1 to lock an end portion of the cup-shaped elastic member 7 to the second bent section 4b of the flange portion 4 of the cover 3. By adopting such a construction is further improved the sealing performance of the crucible 1 as a container but also the attachment of the cover 3 is made more stable, and the cover 3 hardly comes off due to vibrations or the like.

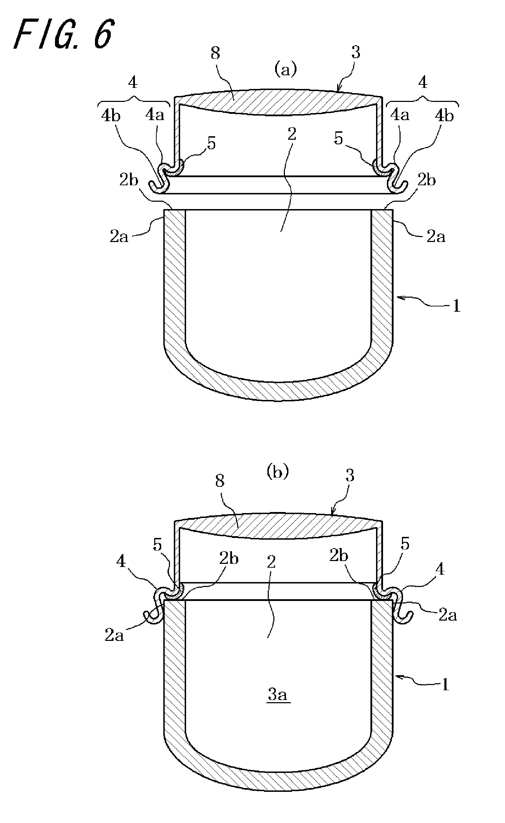

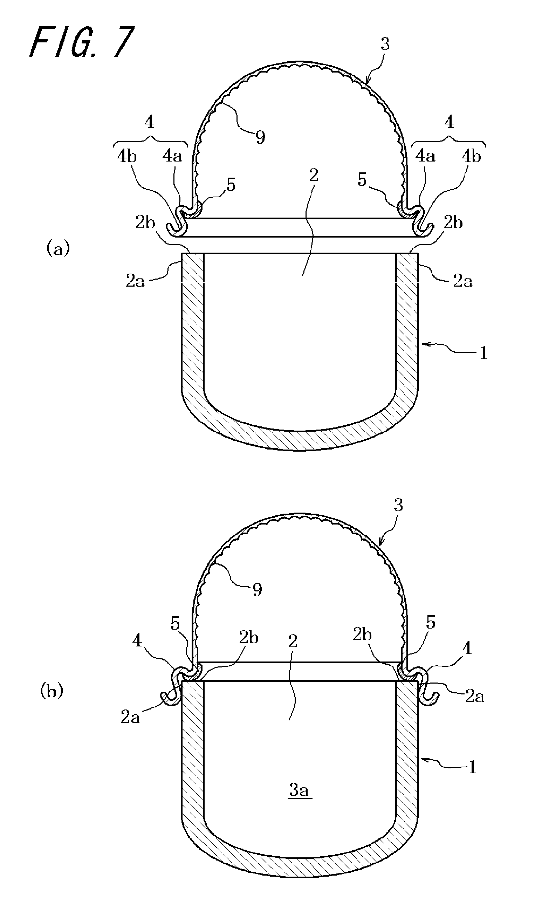

Furthermore, as shown in FIGS. 6 and 7, the cover 3 is protruded outward, whereby it is possible to secure a large space 3a in the crucible, which is advantageous when a mountain of polycrystalline silicon is charged in the production of single crystal silicon as described later. In the cover 3 shown in FIG. 6, an upper face 8 of the cover 3 is transparent and lens-shaped, which is significantly effective to recognize a state inside the crucible 1 in detail during the production even when polycrystalline silicon, dopant and the like are charged into the crucible 1 and the cover 3 is attached to the crucible 1. On the other hand, the cover 3 shown in FIG. 7 is cup-shaped projecting outward, and an inner face thereof is provided with beads 9 for strengthening the cover 3. Such beads 9 are provided through bead processing (also referred to as beading processing). It should be noted that the cover 3 can be subjected to other processing for the purpose of strengthening the cover 3.

In addition, it is preferable to provide an identifier such as a bar-code, a QR code or the like to the cover 3 because it is difficult to engrave a bar-code on a glass material constituting the crucible, and a single body of a crucible and another bar-code are used side by side as a lot identifier. However, by applying a bar-code to the cover may be moved the single body of the crucible. By the way, when a bar-code seal is applied to the conventional wrapping sheet, the transportation as a single body is possible. However, once the wrapping is peeled off for charging polycrystalline Si into the crucible, it is disadvantageous that the wrapping cannot be reused.
Also, it is significantly effective in the production that an identifier capable of including electronic data such as an IC tag or the like, which is becoming common rapidly recently, is attached to the cover 3. Because, when the identifier capable of including electronic data such as an IC tag or the like is attached to the cover 3 and electrical signals are transmitted externally, electronic data can be written in the IC tag and it is possible to easily identify materials charged into the crucible based on such electronic data. In this way, the management of the crucible 1 becomes easier, and the handling of the desired crucible 1 becomes easier. Moreover, the identifier capable of including electronic data such as an IC tag or the like can be reused many times, which is preferable from a viewpoint of reducing the production cost.

When the cover 3 attached to the opening portion 2 of the crucible 1 is removed to use the crucible 1, for example, when the attached cover 3 is removed for charging polycrystalline Si into the crucible 1, it is preferable to invert the crucible 1 and direct the opening portion downward in a vertical direction so as to remove the cover 3. By directing the opening portion of the crucible 1 downward in the removal of the cover 3 can be avoided invasion of foreign substances attached to the surface of the cover 3 such as starting material powder, dust and the like.

Also, the cover can be used repeatedly by washing. The existing sheet is generally disposable because the washing is difficult. Further, since the cover is washable, it can be provided with higher cleanliness. As the cleanliness of the cover, it is preferable that the amount of metal components attached at least on the inner face of the cover is not more than 0.05 ng/cm² in order to enhance the cleanliness in the inner face of the crucible.
Moreover, the cleanliness of the cover can be measured by inductively-coupled plasma mass spectrometry (ICP-MS) after an aqueous solution of hydrogen chloride (HCL) is applied on a surface to be measured such as the inner face of the cover or the like and the applied solution is recovered. In this case, the metal elements to be measured are Na, K, Li, Al, Ca, Co, Cr, Cu, Fe, Mg, Mn, Ni, Ti, Zn, Zr, Ba, P and the like.

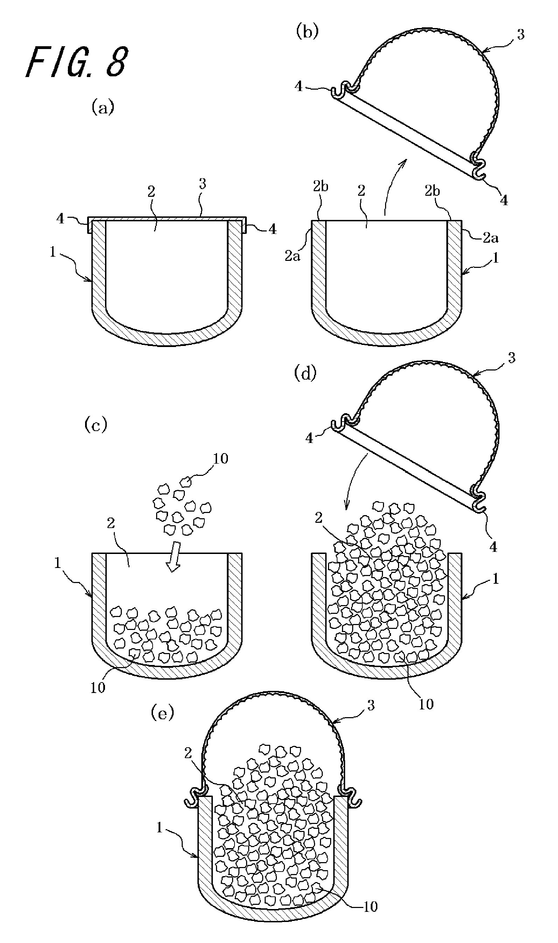

The use of the aforementioned cover 3 enables the handling of the crucible as described below. That is, in the production of single crystal silicon as shown in FIG. 8, from a crucible 1 shipped with a cover 3 as shown in FIG. 8(a) is first removed the cover 3 as shown in FIG. 8(b), and polycrystalline silicon 10 is charged in the crucible 1 as shown in FIG. 8(c), and immediately the cover 3 is mounted onto an opening portion 2 of the crucible 1 as shown in FIG. 8(d). After this, the crucible 1 is stored in a state shown in FIG. 8(e) where the inside of the crucible 1 is blocked from the outside world by the attachment of the cover 3, whereby the starting silicon material in the crucible 1 can be kept free from contamination during waiting time until melting of polycrystalline silicon 10 is conducted.

At this moment, in order to visibly observe the starting silicon material charged into the crucible 1 at a state of attaching the cover 3, it is preferable that at least a part of the cover 3 is rendered to be transparent as an observation window. Of course, the whole of the cover 3 can be made from a transparent material. If visual observation inside the crucible 1 is easy, it is convenient to distinguish a crucible charged with the starting silicon material from a crucible with no content. As the transparent material is preferable polyethylene (PE), polypropylene (PP) or the like.

### EXAMPLE

There are investigated the number of silica powder incorporated into an inner face of a crucible and the crystal yield when a cover as shown in FIGS. 1 to 4 is mounted onto an opening portion of the crucible. For the comparison, the same investigation is conducted when the crucible is covered with a wrapping sheet and when the opening portion of the crucible is left open. The investigation results are shown in Table 1.

Here, the number of silica powder incorporated into the inner face of the crucible is determined by visually counting the number of silica powder and silica pieces attached on the inner face of the crucible before filling polycrystalline silicon and after the crucible is delivered to a pulling step for the production of single crystal silicon and the cover is removed. The unit of the number is "pieces". Moreover, the crystal yield indicates a ratio of crystal weight obtained as a single crystal to weight of the starting material.

**Table 1**

| | Cover (a) FIG. 1 | Cover (b) FIG. 2 | Cover (c) FIG. 3 | Cover (d) FIG. 4 | Conventional wrap | Neither wrap nor cover |
|---|---|---|---|---|---|---|
| Number of silica powder incorporated into inner face of crucible (*) | 5 | 4 | 1 | 0 | 10 | 100 |
| Crystal yield (%) | 81 | 81 | 83 | 83 | 80 | 70 |

| | | | | | | |
|---|---|---|---|---|---|---|
| (*) Measuring condition: Measured after the delivery to a pulling step for the production of single crystal silicon | | | | | | |

### REFERENCE SYMBOLS

- 1: crucible
- 2: opening portion
- 2a: outer peripheral end of opening portion
- 2b: circumferential end face of opening portion
- 3: cover
- 3a: space inside crucible
- 4: flange portion
- 4a: first bent section
- 4b: second bent section
- 5: adhesive member
- 6: band-shaped adhesive member
- 7: cup-shaped elastic member
- 8: upper face of cover
- 9: beads
- 10: polycrystalline silicon

## Claims

1. A cover for a vitreous silica crucible to be mounted onto an opening portion of a vitreous silica crucible, comprising a flange portion in close contact with an outer peripheral end of the opening portion.

2. A cover for a vitreous silica crucible according to claim 1, wherein an adhesive member is disposed on an area of the cover contacting with a circumferential end face of the opening portion.

3. A cover for a vitreous silica crucible according to claim 1, wherein an elastic member is disposed on an area of the cover contacting with a circumferential end face of the opening portion.

4. A cover for a vitreous silica crucible according to any one of claims 1 to 3, wherein an amount of metal components attached at least on an inner surface of the cover is not more than 0.05 ng/cm².

5. A cover for a vitreous silica crucible according to any one of claims 1 to 4, wherein the cover has a flexibility.

6. A cover for a vitreous silica crucible according to any one of claims 1 to 5, wherein the cover has an identifier.

7. A cover for a vitreous silica crucible according to any one of claims 1 to 6, wherein at least a part of the cover is transparent.

8. A vitreous silica crucible having a disk-shaped cover at its opening portion, wherein a flange portion of the cover is fixed to an outer peripheral end of the opening portion into close contact therewith.

9. A method of handling a vitreous silica crucible, wherein a cover as claimed in any one of claims 1 to 7 is mounted onto an opening portion of the vitreous silica crucible during waiting time until polycrystalline silicon is charged into the vitreous silica crucible to conduct melting of polycrystalline silicon in the production of single crystal silicon.
